# EUROPEAN PATENT APPLICATION

(11) **EP 0 881 311 A1**
(43) Date of publication of application: **02.12.1998**
(21) Application number: 98109557.3
(22) Date of filing: 26.05.1998
(51) Int. Cl.: C23C 14/34

(54) **Backing plate for sputtering target**

(30) Priority: 28.05.1997 JP 153100/97
(71) Applicant: JAPAN ENERGY CORPORATION, Minato-ku, Tokyo (JP)
(72) Inventor: Fukuyo, Hideaki, c/o Japan Energy Corporation, Kitaibaraki-shi, Ibaraki-ken (JP); Okabe, Takeo, c/o Japan Energy Corporation, Kitaibaraki-shi, Ibaraki-ken (JP)
(74) Representative: Schwan, Gerhard, Dipl.-Ing.

(57) **Abstract**

There is provided a backing plate material which undergoes little deformation in high temperature environments such as for high power sputtering and which is lightweight and good in thermal conductivity. A backing plate for sputtering target comprises an Al alloy having a 0.2% proof stress of at least 200 MPa, and an assembly of the backing plate and a sputtering target joined together. Preferably used as the backing plate is an Al alloy which consists of from 0.1 to 7 mass% Cu, from 1 to less than 10 mass% in all of elements selected from the group consisting of Si, Fe, Cu, Mn, Mg, Zn, Cr, V, Zr and Ti, the total of elements other than Al being less than 10 mass%, and the balance Al.

## Description

### [Backfield of the invention]

This invention relates to a backing plate for a sputtering target and also to a sputtering target-backing plate assembly.

Sputtering process is now extensively used as a method for forming thin films of semiconductors and the like. Each sputtering target is joined to a base known as backing plate for its cooling and for the convenience of mounting in a sputtering system.

Until recently, backing plates were usually made of oxygen-free copper and were brazed to sputtering targets using low-melting point brazing metal such as an In alloy. Joining with such a low-melting point brazing metal is not usable in high temperature environments and is not applicable for current high power sputtering. More recent practice, therefore, has been to use a unitary target consisting of a backing plate and a target of the same material or one made by solid phase bonding of a backing plate and a target.

The unitary target, composed of a backing plate and a target of the same material, may have low mechanical strength. For example, an Al target-backing plate assembly can undergo deformation during sputtering. When the deformation occurs, the distance between the target and wafer varies, impairing the uniformity of the deposited film on the wafer, with large adverse affects upon the yield and reliability of the resulting devices.

The solid phase-bonded target can have a problem similar to that of the unitary target, depending on the choice of material for the backing plate. Solid phase bonding is a method for effecting an interfacial bonding by the application of pressure to a sputtering target and a backing plate at a certain temperature so as to maintain the solid phase of the target. In the case of Al alloy or the like conventionally used, owing to its low mechanical strength, its deformation during the course of sputtering or solid phase bonding has been inevitable.

It was then considered to use a backing plate of a material having grater mechanical strength than the conventional Al alloy or the like and which suffers a minimum of loss of the mechanical strength under the solid phase bonding conditions, e.g., a Cu alloy or Ti alloy. However, a Cu alloy has about three times the density of Al alloy and is so heavy, especially for a large diameter target, that it is much difficult to handle. On the other hand, a Ti alloy is less than twice as dense as Al alloy and a reduction in weight is possible. However, the generally low thermal conductivity makes Ti rather unsuitable for the cooling of a target.

### [Object of the invention]

The object of this invention is to provide backing plate materials that undergo little deformations in high temperature environments such as for high power sputtering and have light weight and excellent thermal conductivity.

### [Summary of the invention]

The present inventors have intensively studied on the solution of the foregoing problems and have found that, in order to prevent the deformation of a backing plate of a target during sputtering, a material having a 0.2% proof stress of at least 200 MPa must be used for the backing plate. Further considerations of the usage as a member for the purpose of cooling and easy handling make a light-weight, thermally conductive Al alloy an optimum choice. It has been found that Al alloys with such features are seldom available and are restricted only to a specific class of Al alloys containing from 0.1 to 7 mass% of Cu as an additional element, and further containing from 1 to less than 10 mass% in total of elements selected from the group consisting of Si, Fe, Cu, Mn, Mg, Zn, Cr, V, Zr, and Ti.

On the basis of the above findings, this invention provides:
1. a backing plate for sputtering target characterized by being made of an Al alloy having a 0.2% proof stress of at least 200 MPa.
2. a backing plate according to 1 above characterized in that the Al alloy consists of from 0.1 to 7 mass% Cu, from 1 to less than 10 mass% in total of elements selected from the group consisting of Si, Fe, Cu, Mn, Mg, Zn, Cr, V, Zr, and Ti, the total of elements other than Al being less than 10 mass%, and the balance Al.
3. A sputtering target-backing plate assembly which comprises a sputtering target and a backing plate joined together, characterized in that the backing plate is made of an Al alloy having a 0.2% proof stress of at least 200 MPa.
4. An assembly according to 3 above characterized in that the backing plate is made of an Al alloy which consists of from 0.1 to 7 mass% Cu, from 1 to less than 10 mass% in total of elements selected from the group consisting of Si, Fe, Cu, Mn, Mg, Zn, Cr, V, Zr, and Ti, the total of elements other than Al being less than 10 mass%, and the balance Al.
5. An assembly according to 3 or 4 above characterized in that the sputtering target and backing plate have solid-phase bonded interface therebetween.
6. An assembly according to 3, 4, or 5 above characterized in that the sputtering target is made of Al, Ti, Cu, Ni, Co, Ta, Mo, W, Cr, or Si or an alloy consisting mainly of such elements.

### [Embodiments of the invention]

For the purposes of the invention the term "backing plate" is used to mean a member of metallic material to be joined or bonded to the rear side of a sputtering target so as to cool the target material and facilitate the mounting of the target in a sputtering system. Also, the term "sputtering target-backing plate assembly" as used herein means an assembly of a sputtering target and a backing plate joined or bonded together.

The backing plate according to this invention is characterized by being made of an Al alloy having a 0.2% proof stress of at least 200 MPa.

If the 0.2% proof stress of the backing plate is less than 200 MPa, sputtering will cause the assembly to camber beyond an allowable range. The camber is undesirable in that it adversely affects the uniformity of the thin film deposited by sputtering. Experiment showed that a camber deformation of more than 2 mm will seriously deteriorate the film uniformity. If the deformation during sputtering is to be limited to less than 2 mm, the backing plate should have a 0.2% proof stress of greater than 200 MPa.

When the mechanical strength is the only consideration, the use of a conventional Cu alloy, Ti alloy or the like might be possible. However, a Cu alloy has a high density and is too heavy, especially as a backing plate for large-size target, to handle. A Ti alloy is lighter in weight but is nevertheless undesirable either, because its low thermal conductivity results in a poor cooling efficiency. The Al alloy of the invention is desirable also in viewpoint of its superior thermal conductivity and lighter weight.

A material that can be provided under this invention as satisfying all the afore-mentioned requirements of high 0.2% proof stress, good thermal conductivity, and lightness is an Al alloy which consists of from 0.1 to 7 mass% Cu, from 1 to less than 10 mass% in total of elements selected from the group consisting of Si, Fe, Cu, Mn, Mg, Zn, Cr, V, Zr, and Ti, the total of elements other than Al being less than 10 mass%, and the balance Al.

A Cu content of less than 0.1 mass% renders the backing plate impossible to attain a 0.2% proof stress of 200 MPa or more, but more than 7 mass% Cu is unwanted either since it seriously reduces the corrosion resistance.

If the total content of the elements selected from the group consisting of Si, Fe, Cu, Mn, Mg, Zn, Cr, V, Zr, and Ti is outside the specified range of from 1 to less than 10 mass%, it is again impossible to obtain a 0.2% proof stress of at least 200 MPa. A decrease in corrosion resistance is another disadvantage.

If the total of elements other than Al is more than 10 mass% the result is undesirable either in that the corrosion resistance deteriorates likewise.

Typically alloys complying with JIS A2219 and JIS A6061 (JIS: Japanese Industrial Standard) as listed below may be cited as examples of the invention, although the invention is not limited thereto.

| A2219 alloy | A6061 alloy |
|---|---|
| Si : 0.20 or less | Si : 0.40-0.8 |
| Fe : 0.30 or less | Fe : 0.7 or less |
| Cu : 5.8-6.8 | Cu : 0.15-0.40 |
| Mn : 0.20-0.40 | Mn : 0.25 or less |
| Mg : 0.02 or less | Mg : 0.8-1.2 |
| Zn : 0.10 or less | Zn : 0.25 or less |
| Ti : 0.02-0.10 | Ti : 0.25 or less |
| Zr : 0.10-0.25 | Cr : 0.04-0.35 |
| V : 0.05-0.15 | |

| Others | Others |
|---|---|
| each : 0.05 or less | each : 0.05 or less |
| total: 0.15 or less | total: 0.15 or less |
| Al : balance | Al : balance |
| (unit: in mass%) | |

Backing plates of this invention made of these Al alloys can attain a 0.2% proof stress of at least 200 MPa by conditioning under appropriate conditions. Optimum conditioning conditions vary with alloy compositions, but a generally practical process consists, e.g., of a solution treatment at 500-550°C and a subsequent aging treatment at 150-200°C.

As will be described more fully later, it is alternatively possible to effect the solid phase bonding of a target and a backing plate by hot isostatic pressing (HIP), hot pressing, explosive welding, hot rolling, or other technique and then condition the material, when necessary, by aging.

The use of a strong material having a 0.2% proof stress of 200 MPa or more as a backing plate renders it possible to control the camber of the sputtering target-backing plate assembly during sputtering within a range below 2 mm.

The backing plate of Al alloy is machined, e.g., to, but not limited to, be a disk, square plate, or the like; i.e., to any other shape the corresponding sputtering target may take.

The backing plate of this invention may be joined or bonded to a target of whatever material. From the viewpoint of solid phase bonding, it can effectively be combined with a target of Al, Ti, Cu, Ni, Co, Ta, Mo, W, Cr, or Si or of an alloy based on such an element. A target of Al is by far the most effectively compatible with the backing plate owing to their similarity in thermal expansion coefficient and a minimum of camber problem due to a negligible coefficient difference.

The backing plate and sputtering target according to this invention may be assembled by joining or bonding in a variety of ways, e.g., by solid phase bonding, brazing, screwing, or other mechanical joining technique.

Particularly desirable is bonding in solid phases.

Solid phase bonding is a method of forming an interface between a target material and a backing plate while the both are maintained in solid phase conditions, by applying thereto high enough heat and pressure to induce the diffusion of atoms along the interface for bonding, without entailing any unfavorable effect such as crystal growth in the target material. Depending on the type of the target material, an insert is used or a preliminary treatment of the surfaces for solid phase bonding is done according to the necessity. For example, with an Al target it is common practice to use a thin foil of Ag, Cu, Ni or the like as an insert. It is sometimes replaced by a preliminary surface treatment whereby a thin film of Ag or the like is deposited by ion plating or other similar technique.

Actual conditions for solid phase bonding vary with target material-backing plate combinations. In the case of an Al target, e.g., solid phase bonding can be carried out by maintaining it together with a backing plate in a vacuum below 0.1 Torr at a temperature of 150-300°C and a pressure of 1.0-20 kg/mm². When necessary, as noted above, an even greater strength can be imparted to the assembly by aging treatment after the solid phase bonding.

### [Examples]

This invention is illustrated by the following examples.

### (Example 1)

As a backing plate, a disk 540 mm in dia. and 13 mm thick was made using an Al alloy (JIS A2219) of the following composition:
Si: 0.1 mass%; Fe: 0.2 mass%; Cu: 6.5 mass%;
Mn: 0.3 mass%; Mg: 0.01 mass%; Zn: 0.05 mass%;
V: 0.1 mass%; Zr: 0.2 mass%; Ti: 0.08 mass%;
Miscellaneous: less than 0.1 mass%; and Al: the balance.

This backing plate had a 0.2% proof stress of 270 MPa.

As a sputtering target, a circular disk 440 mm in dia. and 13 mm thick was made of an Al-0.5%Cu alloy. The composition of the sputtering target was as follows:
Cu: 0.5 mass%; Si: 0.6 ppm; Fe: 0.2 ppm; Cu: 0.5 ppm;
Mn: 0.07 ppm; Mg: 0.8 ppm; Cr: 0.02 ppm; Zn: 0.4 ppm;
V: 0.05 ppm; Zr: 0.04 ppm; Ti: 0.06 ppm; and
Al: the balance.

The backing plate and sputtering target were kept contact together in a vacuum below 0.1 Torr at 150-300°C and 1.0-20 kg/mm² for solid phase bonding to manufacture a sputtering target-backing plate assembly.

### (Example 2)

A sputtering target-backing plate assembly was made in the manner described in Example 1 with the exception that for the backing plate an Al alloy (JIS A6061) of the following composition was used.
Si: 0.6 mass%; Fe: 0.5 mass%; Cu: 0.3 mass%;
Mn: 0.1 mass%; Mg: 1 mass%; Cr, 0.2 mass%;
Zn: 0.15 mass%; Ti, 0.1 mass%;
Miscellaneous: less than 0.1 mass%; and Al: the balance.

This backing plate possessed a 0.2% proof stress of 225 MPa.

### (Comparative Example 1)

Using an Al alloy (JIS A5052) of the following composition for the backing plate, a sputtering target-backing plate assembly was made in the same way as described in Example 1.
Si: 0.25 mass%; Fe: 0.3 mass%; Cu: 0.05 mass%;
Mn: 0.06 mass%; Mg: 2.5 mass%; Cr, 0.3 mass%;
Zn: 0.07 mass%; Miscellaneous: less than 0.1 mass%; and
Al: the balance.

The 0.2% proof stress of this backing plate was 87 MPa.

### (Comparative Example 2)

A sputtering target-backing plate assembly was made following the procedure of Example 1 excepting the use for the backing plate of an Al alloy (JIS A2219) of the following composition:
Si: 0.1 mass%; Fe: 0.2 mass%; Cu: 6.5 mass%;
Mn: 0.3 mass%; Mg: 0.01 mass%; Zn: 0.05 mass%;
V: 0.1 mass%; Zr: 0.2 mass%; Ti: 0.08 mass%;
Miscellaneous: less than 0.1 mass%; and Al: the balance.

The backing plate of Comparative Example 2 had the same alloy composition as that of Example 1. However, different conditioning conditions reduced its 0.2% proof stress to 148 MPa, or about half the value in Example 1.

### (Comparative Example 3)

Using an Al-0.5%Cu alloy, a unitary sputtering target in which the target and backing plate each of the same composition are integrally united was made. The particulars of the alloy composition were as follows:
Cu: 0.5 mass%; Si: 0.6 ppm; Fe: 0.2 ppm; Cu: 0.5 ppm;
Mn: 0.07 ppm; Mg: 0.8 ppm; Cr: 0.02 ppm; Zn: 0.4 ppm;
V: 0.05 ppm; Zr: 0.04 ppm; Ti: 0.06 ppm;
Miscellaneous: less than 0.1 mass%; and Al: the ba lance.

This unitary sputtering target had a 0.2% proof stress of 31 MPa.

### (Comparative Example 4)

As a backing plate, a disk 540 mm in dia. and 13 mm thick was made using a Cu-1%Cr alloy of the following composition:
Cr: 1 mass%; Fe: 13 ppm; Mg: less than 0.8 ppm;
Al: 0.59 ppm; Miscellaneous: less than 0.1 mass%; and
Cu: the balance.

This backing plate exhibited a 0.2% proof stress of 270 MPa.

As a sputtering target, a circular disk 440 mm in dia. and 13 mm thick was made of an Al-0.5%Cu alloy. The composition of the sputtering target was as follows:
Cu: 0.5 mass%; Si: 0.6 ppm; Fe: 0.2 ppm; Cu: 0.5 ppm;
Mn: 0.07 ppm; Mg: 0.8 ppm; Cr: 0.02 ppm; Zn, 0.4 ppm;
V: 0.05 ppm; Zr: 0.04 ppm; Ti: 0.06 ppm;
Miscellaneous: less than 0.1 mass%; and Al: the ba lance.

The backing plate and sputtering target were bonded in solid phases by maintaining them together in a vacuum below 0.1 Torr at 150-300°C and 1.0-20 kg/mm². A sputtering target-backing plate assembly was thus made.

### (Results)

Each of the sputtering target-backing plate assemblies of Examples and Comparative Examples was mounted in a sputtering system. With it a sputtering test was conducted to deposit a thin Al alloy film over a 12 in.-dia. Si substrate using a sputtering power supply of 20 kW. The test was carried on until the target life expires, and the amount of camber of the assembly was measured. Also, the sheet resistance distribution in the thin Al alloy film deposited on the Si substrate was determined. With all the assemblies tested, the material compositions and 0.2% proof stress values of the backing plates, the amounts of camber and weights of the assemblies, and the dispersions 3σ of sheet resistance distribution in the thin films thus deposited (σ = standard deviation of the sheet resistance distribution) values are given in Table 1.

**[Table 1]**

| | | Example 1 | Example 2 | Comp.Ex. 1 | Comp.Ex. 2 | Comp.Ex. 3 | Comp.Ex. 4 |
|---|---|---|---|---|---|---|---|
| Backing plate composition | Si | 0.1mass% | 0.6mass% | 0.25mass% | 0.1mass% | 0.6 ppm | - |
| | Fe | 0.2mass% | 0.5mass% | 0.3mass% | 0.2mass% | 0.2 ppm | 13 ppm |
| | Cu | 6.5mass% | 0.3mass% | 0.05mass% | 6.5mass% | 0.5mass% | bal. |
| | Mn | 0.3mass% | 0.1mass% | 0.06mass% | 0.3mass% | 0.07ppm | - |
| | Mg | 0.01mass% | 1mass% | 2.5mass% | 0.01mass% | 0.8ppm | <0.01ppm |
| | Cr | - | 0.2mass% | 0.3mass% | - | 0.02ppm | 1 mass% |
| | Zn | 0.05mass% | 0.15mass% | 0.07mass% | 0.05mass% | 0.4ppm | - |
| | V | 0.1mass% | - | - | 0.1mass% | 0.05ppm | - |
| | Zr | 0.2mass% | - | - | 0.2mass% | 0.04ppm | - |
| | Ti | 0.08mass% | 0.1mass% | - | 0.08mass% | 0.06ppm | - |
| | misc. | <0.1mass% | <0.1mass% | <0.1mass% | <0.1mass% | <0.1mass% | <0.1mass% |
| | Al | bal. | bal. | bal. | bal. | bal. | 0.59ppm |
| 0.2% proof stress, MPa | | 270 | 255 | 87 | 148 | 31 | 250 |
| Camber, mm | | 0.1 | 0.15 | 4 | 2.7 | 7 | 0.2 |
| Assembly weight, kg | | 12.5 | 12.5 | 12.5 | 12.5 | 12.5 | 30 |
| Dispersion of thin film sheet resistance 3σ, % | | 3.2 | 3.2 | 6.4 | 5.3 | 8.1 | 3.2 |

The assemblies of Examples 1 and 2 showed cambers of less than 0.2 mm. In contrast with them, the assemblies of Comparative Examples 1 and 2 and the unitary target of Comparative Example 3 cambered much more. The assembly of Comparative Example 4, which used a Cu alloy backing plate, showed a much lower camber value but weighed more than twice the assemblies of this invention, presenting a handling problem.

The sheet resistance distributions in the thin films thus deposited indicated the possibility of obtaining a uniform thin film in Examples 1 and 2 of this invention. In Comparative Examples 3 and 4, by contrast, the film uniformity was not satisfactory.

### [Advantages of the invention]

The sputtering target-backing plate assembly according to this invention comprises a sputtering target and a backing plate joined or bonded together, particularly by solid phase bonding, the backing plate being made of an Al-Cu alloy which consists of 0.1 to 7 mass% Cu, from 1 to less than 10 mass% in all of elements selected from the group consisting of Si, Fe, Cu, Mn, Mg, Zn, Cr, V, Zr, and Ti, and the balance Al, said backing plate having a 0.2% proof stress of at least 200 MPa. Since the camber of the assembly is as slight as 0.2 mm or less, the thin film that is deposited by sputtering with the assembly exhibits excellent uniformity. Moreover, the assembly weighs less than a half the weight of an assembly using a Cu alloy backing plate and hence is easier to handle.

## Claims

1. A backing plate for sputtering target characterized by being made of an Al alloy having a 0.2% proof stress of at least 200 MPa.

2. A backing plate according to claim 1 wherein the Al alloy consists of from 0.1 to 7 mass% Cu, from 1 to less than 10 mass% in total of elements selected from the group consisting of Si, Fe, Cu, Mn, Mg, Zn, Cr, V, Zr, and Ti, the total of elements other than Al being less than 10 mass%, and the balance Al.

3. A sputtering target-backing plate assembly which comprises a sputtering target and a backing plate joined together, characterized in that the backing plate is made of an Al alloy having a 0.2% proof stress of at least 200 MPa.

4. An assembly according to claim 3 wherein the backing plate is made of an Al alloy which consists of from 0.1 to 7 mass% Cu, from 1 to less than 10 mass% in total of elements selected from the group consisting of Si, Fe, Cu, Mn, Mg, Zn, Cr, V, Zr, and Ti, the total of elements other than Al being less than 10 mass%, and the balance Al.

5. An assembly according to claim 3 or 4 wherein the sputtering target and backing plate are joined in solid phase bonding.

6. An assembly according to claim 3 or 4 wherein the sputtering target is made of Al, Ti, Cu, Ni, Co, Ta, Mo, W, Cr, or Si or an alloy consisting mainly of such elements.

7. An assembly according to claim 1 or 2 wherein the sputtering target and backing plate are joined in solid phases bonding and the sputtering target is made of Al, Ti, Cu, Ni, Co, Ta, Mo, W, Cr, or Si or an alloy consisting mainly of such elements.
